# EUROPEAN PATENT SPECIFICATION

(11) **EP 0 660 396 B1**
(45) Date of publication and mention of the grant of the patent: **04.11.1998**
(21) Application number: 93830523.2
(22) Date of filing: 24.12.1993
(51) Int. Cl.: H01L 23/051, H01L 23/48

(54) **Power MOS device chip and package assembly**
MOS-Leistungs-Chip-Typ und Packungszusammenbau
Ensemble de dispositif de puissance du type puce MOS et son empaquetage

(43) Date of publication of application: 28.06.1995
(73) Proprietor: Consorzio per la Ricerca sulla Microelettronica nel Mezzogiorno, 95121 Catania (IT)
(72) Inventor: Ronsisvalle, Cesare, I-95126 Catania (IT)
(74) Representative: Mittler, Enrico

(56) References cited:
- EP-A- 0 421 344
- EP-A- 0 433 650

## Description

The present invention relates to a power MOS device chip and package assembly.

Power semiconductor devices having large chip size, with a chip diameter larger than 2 or 3 cm, are generally packaged in ceramic packages, such as the so-called "press-pack" package, which, differently from plastic packages, guarantee a higher degree of heat dissipation.

Due to the high power managed by the semiconductor device, the contact area between the device chip and the external leads (normally constituted by nickel-plated copper) must be as wide as possible; this makes the use of wire bonding techniques, commonly used for power devices with lower power ratings packaged in plastic or metallic packages, impracticable; the leads are therefore electrically connected to the chip by means of molybdenum or tungsten plates which at one side are in physical contact with the leads, while at the other side are in electrical contact with the chip through thin washers or discs of silver or silver-plated copper.

To achieve a good electrical contact, and thus to reduce the contact resistance, the contact pressure between the leads, the plates, the washers or the discs and the chip must be rather high.

This technique is efficiently used in connection with semiconductor devices such as diodes, silicon controlled rectifiers (SCRs), gate turn-off thyristors (GTOs), triacs and so on, but its application to MOS power devices (power MOSFETs, IGBTs, MCTs, etc.) poses some problems: since in fact such devices are characterized by having fragile oxide and polysilicon layers at their surface, the contact pressures required to achieve good electrical contact would cause such layers to be damaged.

It is however known that power MOS devices are expected to replace the more common thyristors even in the high-power field.

EP-A-0 433 650 discloses a semiconductor device having a bipolar-MOS composite element pellet suitable for a pressure contacted structure. The pressure of the source compression electrode plate is exerted directly over the elementary functional cells of the power MOSFET, wherein a thin gate oxide layer separates the polysilicon gate layer from the silicon substrate. For this reason, it is impossible to use high contact pressures, which could damage the gate and gate oxide layers.

In view of the state of the art described, object of the present invention is to realize a power MOS device chip and package assembly which is not affected by the abovementioned drawbacks, while assuring good heat dissipation characteristics and low contact resistance.

According to the present invention, such object is attained by means of a power MOS device chip and package assembly as set forth in claim 1.

Thanks to the present invention, it is possible to realize power MOS devices which can be packaged using the same techinque used for traditional power semiconductor devices which are not affected by problems related to fragile surface structures.

The features of the present invention will be made more evident by the following detailed description of one embodiment, illustrated as a non-limiting examples in the annexed drawings, wherein:
Figure 1 is an exploded perspective view of a power MOS device chip and package assembly according to the invention;
Figure 2 is a cross-sectional view of the assembly of Figure 1;
Figure 3 is a schematic top plan view of a part of the power MOS device chip of Figure 1;
Figure 4 is a cross-sectional view taken along the plane IV-IV of Figure 3.

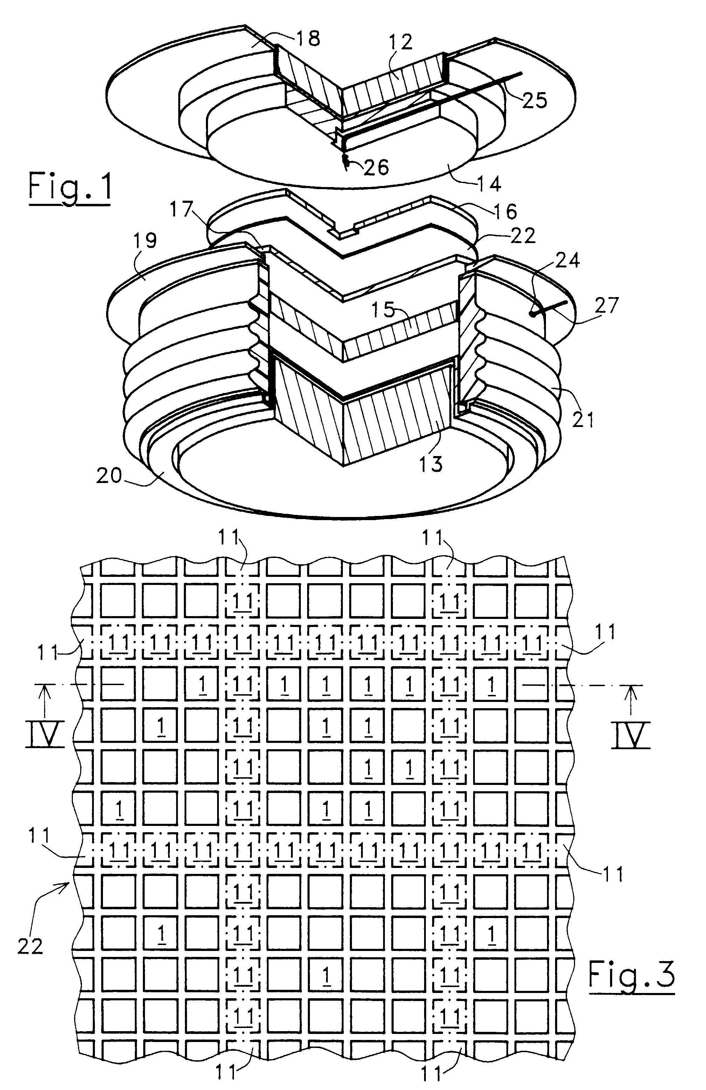

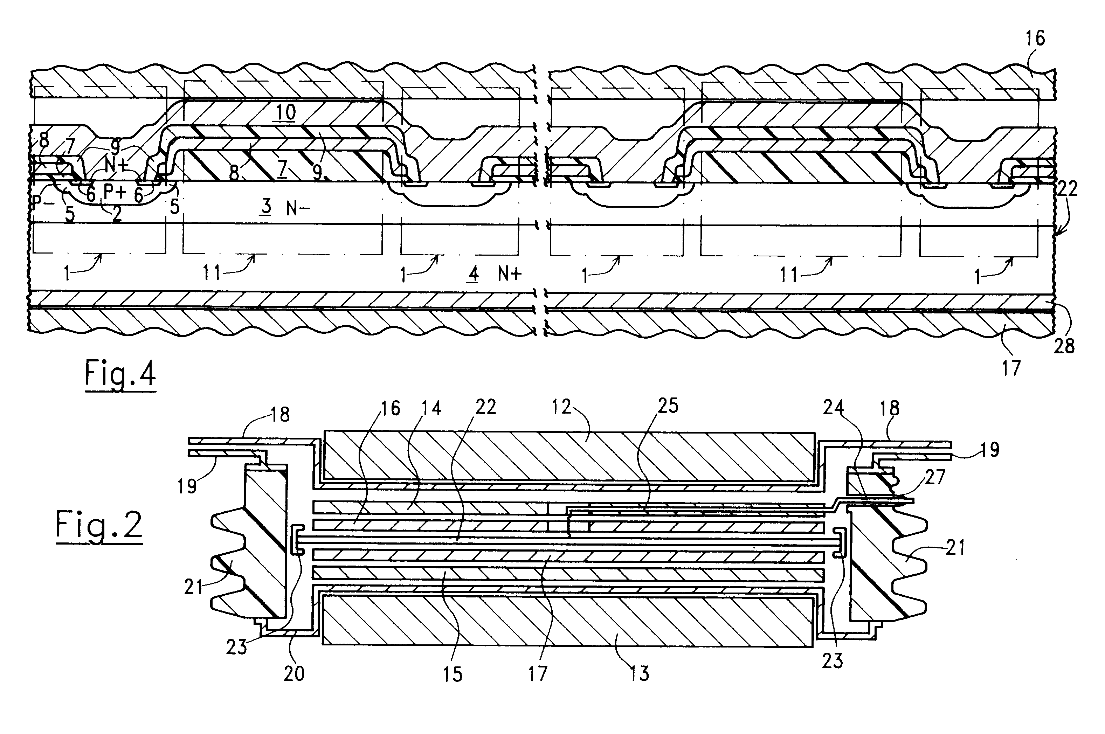

A so-called "press-pack" ceramic package, shown in Figures 1 and 2 and described for example in the European Patent Application No. 91830215.9 filed on May 23, 1991, for a power semiconductor device chip 22 comprises a first pair of plates 12 and 13 of nickel-plated copper, constituting two external electrodes of the power device packaged therein, a second pair of plates 14 and 15 of molybdenum, a contact washer 16 of silver-plated copper or silver or molybdenum, a contact disc 17 also of silver-plated copper or silver or molybdenum, an upper flange 18, an intermediate flange 19 and a lower flange 20 all in nickel-plated copper, and a ceramic body 21. The power device chip 22 is interposed between the contact washer 16 and the contact disc 17, and is kept in position by a plastic washer 23 (Fig. 2). The ceramic body 21 is provided with a passing-through hole 24 for a metallic wire 25 supplying a control signal for the power device, the metallic wire 25 ending with a spring-shaped end 26; the passing-through hole 24 is externally connected to a terminal 27.

In Figure 3 a top view of a part of the chip 22 is shown. A power MOS device, for example a power MOSFET, is composed in a per-se known way by a plurality of functionally active elementary cells 1, also called "source cells"_{,} disposed to form a two-dimensional array. As shown in Figure 4, the chip 22 comprises an N+ semiconductor substrate 4 over which an N-epitaxial layer 3 is grown. Each source cell 1 represents a functionally active unit of the whole power MOSFET, and contributes by a respective fraction to the overall power MOSFET current capability. Each source cell 1 comprises a P+ deep body region 2 obtained into the N- epitaxial layer 3. The P+ deep body region 2 is laterally surrounded by and merged with a P- annular region 5 constituting a channel region of the source cell 1; inside the P type semiconductor region composed by the P- annular region 5 and by the P+ deep body region 2, an N+ annular region 6 is obtained constituting a source region of the elementary source cell 1. At a top surface of the N-epitaxial layer 3, an oxide layer 7 having a typical thickness of about 0.85 µm extends over the P- annular region 5 and partially over the N+ annular region 6 and constitutes a gate oxide layer of the source cell 1; a polysilicon layer 8 is superimposed over and autoaligned with the underlying oxide layer 7, and constitutes a polysilicon gate layer of the source cell 1. An insulating layer 9 covers the polysilicon layer 8 and is selectively etched to form contact areas to allow an overlying metal layer 10 to come into contact with both the N+ annular region 6 and the P+ deep body region 2; the metal layer 10 contacts in the same way all the elementary source cells 1 and constitutes a source electrode for the power MOSFET. A bottom surface of the N+ substrate 4 is covered by a metal layer 28 constituting a drain electrode for the power MOSFET. A contact area for the polysilicon gate layer 8 is also provided at the top surface of the chip 22, even if not shown in the drawings, to allow the spring-shaped end 26 of the wire 25 to electrically contact the polysilicon gate layer 8 when the chip 22 is packaged in the "press-pack" package described above.

According to the present invention, the bidimensional array of source cells 1 includes dummy cells 11, which are inactive from the functionally point of view and do not contribute to the overall current capability of the power MOSFET.

In the example of Figure 3 such dummy cells 11 are disposed to form a grid with lines of dummy cells 11 regularly spaced in both the horizontal dimensions by an equal number of source cells 1. The dummy cells 11 have horizontal dimensions substantially identical to those of the source cells 1, but different vertical dimension. This clearly appears in Figure 4, wherein the cross-section of two of such dummy cells 11 is shown.

Differently from the elementary source cells 1, no P+ deep body region 2, P- annular region 5 and N+ annular region 6 are provided in the dummy cell 11; furthermore, the thickness of the oxide layer 7, typically of 2 µm, is greater than the thickness of said oxide layer 7 in the source cells 1: this causes the surface of the metal layer 10 to be elevated over the dummy cells 11 with respect to the source cells 1.

When the chip 22 is to be packaged into the press-pack package described above, the chip 22 is inserted into the ceramic body 21 so that the metal layer 28 leans on the contact disc 17, which in turn leans on the plate 15. The bottom of the body 21 is closed by the lower flange 20 and by the plate 13. The contact washer 16 is then deposited over the top surface of the chip 22, i.e. over the metal layer 10. The top of the body 21 is closed by the plate 26 and by the upper flange 18. To achieve a good electrical contact, the plate 12 is pressed down to put the washer 16 into close mechanical contact with the top surface of the chip 22.

Thanks to the fact that the metal layer 10 protrudes superiorly over the dummy cells 11 with respect to the source cells 1, the contact washer 16 leans on the dummy cells 11 and not on the source cells 1; the contact pressure is thus entirely sustained by the dummy cells 11 which, because of the greater thickness of the oxide layer 7, are more resistant to mechanical stresses than the source cells 1. It is thus possible to obtain a good electrical contact without damaging the power MOSFET.

Various topological distribution of dummy cells 11 and elementary source cells 1 are possibile, depending on the contact pressure, i.e. on the contact resistance, requested.

## Claims

1. Power MOS device chip and package assembly, the package comprising a thermally conducting body (21) containing the chip (22) and an electrically conducting contact washer (16) to be pressed in closed mechanical contact with a top surface of the chip (22) and with a first external electrical terminal plate (12), said top surface of the chip being represented by a metal layer (10) covering a conductive material gate layer (8) of the power MOS device, said gate layer (8) being insulated from an underlying semiconductor material (3) by an insulating layer (7), the power MOS device being composed of a plurality of functionally active elementary cells (1) obtained in respective portions of the chip (22) and a plurality of functionally inactive regions (11), said insulating layer (7) being thicker in the functionally inactive regions (11) than in said functionally active elementary cells (1), the gate layer (8) and the metal layer (10) being consequently elevated at said functionally inactive regions with respect to the functionally active elementary cells (1), so that the pressure exerted by the contact washer (16) is entirely sustained by said functionally inactive regions (11).

2. Power MOS device chip and package assembly according to claim 1, characterized in that said functionally inactive regions (11) are intercalated to the functionally active elementary cells (1).

3. Power MOS device chip and package assembly according to any one of the preceding claims, characterized in that said thermally conducting body (21) of the package is made of ceramic.

4. Power MOS device chip and package assembly according to claim 3, characterized in that the package is of the "press-pack" type, further comprising an electrically conducting contact disc (17) in mechanical contact with a bottom surface (28) of the chip (22), a first electrically conducting plate (14) superimposed over the contact washer (16), a second electrically conducting plate (15) underlying the contact disc (17), the package further comprising an upper flange (18) closing a top opening of the body (21) and a lower flange (20) closing a bottom opening of the body (21), and a second external electrical terminal plate (13), each of said two external plates (12,13) being in contact with a respective one of said two flanges (18,20) and constituting the external electrical terminals of the power MOS device.

## Patentansprüche

1. Anordnung aus einem Leistungs-MOS-Vorrichtungs-Chip und einem Gehäuse, wobei das Gehäuse einen wärmeleitfähigen Körper (21), der den Chip (22) enthält, und eine elektrisch leitfähige Kontaktunterlegscheibe (16) aufweist, die in geschlossenen mechanischen Kontakt mit einer oberen Oberfläche des Chip (22) sowie mit einer ersten äußeren elektrischen Anschlußplatte (12) zu drücken ist, wobei die obere Oberfläche des Chip durch eine Metallschicht (10) gebildet ist, die eine Gateschicht (8) aus leitfähigem Material der Leistungs-MOS-Vorrichtung bedeckt, wobei die Gateschicht (8) von einem darunterliegenden Halbleitermaterial (3) durch eine Isolierschicht (7) isoliert ist, wobei die Leistungs-MOS-Vorrichtung aus einer Mehrzahl von funktionsmäßig aktiven Elementarzellen (1), die in jeweiligen Bereichen des Chip (22) gebildet sind, und aus einer Mehrzahl von funktionsmäßig inaktiven Bereichen (11) gebildet ist, wobei die Isolierschicht (7) in den funktionsmäßig inaktiven Bereichen (11) dicker ist als in den funktionsmäßig aktiven Elementarzellen (1), wobei die Gateschicht (8) und die Metallschicht (10) als Ergebnis hiervon in den funktionsmäßig inaktiven Bereichen gegenüber den funktionsmäßig aktiven Elementarzellen (1) höher angeordnet sind, so daß der von der Kontaktunterlegscheibe (16) ausgeübte Druck vollständig von den funktionsmäßig inaktiven Bereichen (11) aufgenommen wird.

2. Anordnung aus einem Leistungs-MOS-Vorrichtungs-Chip und einem Gehäuse nach Anspruch 1,
dadurch gekennzeichnet, daß die funktionsmäßig inaktiven Bereiche (11) zwischen den funktionsmäßg aktiven Elementarzellen (1) eingefügt sind.

3. Anordnung aus einem Leistungs-MOS-Vorrichtungs-Chip und einem Gehäuse nach einem der vorausgehenden Ansprüche,
dadurch gekennzeichnet, daß der wärmeleitfähige Körper (21) des Gehäuses aus Keramikmaterial hergestellt ist.

4. Anordnung aus einem Leistungs-MOS-Vorrichtungs-Chip und einem Gehäuse nach Anspruch 3,
dadurch gekennzeichnet, daß es sich bei dem Gehäuse um eines des "Press-Pack"-Typs handelt, weiterhin mit einer elektrisch leitfähigen Kontaktscheibe (17) in mechanischem Kontakt mit einer Bodenfläche (28) des Chip (22), mit einer ersten elektrisch leitfähigen Platte (14), die über der Kontaktunterlegscheibe (16) angeordnet ist, mit einer zweiten elektrisch leitfähigen Platte (15), die unter der Kontaktscheibe (17) angeordnet ist, wobei das Gehäuse ferner einen oberen Flansch (18), der eine obere Öffnung des Körpers (21) verschließt, und einen unteren Flansch (20), der eine untere Öffnung des Körpers (21) verschließt, sowie eine zweite äußere elektrische Anschlußplatte (13) aufweist, wobei jede der beiden äußeren Platten (12, 13) sich mit einem jeweiligen der beiden Flansche (18, 20) in Berührung befindet und die äußeren elektrischen Anschlüsse der Leistungs-MOS-Vorrichtung bildet.

## Revendications

1. Ensemble puce et boîtier de dispositif MOS (métal-oxyde-semi-conducteur) de puissance, le boîtier comprenant un corps (21) conducteur de la chaleur contenant la puce (22) et une rondelle (16) de contact, conductrice de l'électricité, destinée à être pressée en contact mécanique étroit avec la surface supérieure de la puce (22) et avec une première plaque (12) de borne électrique externe, ladite surface supérieure de la puce étant représentée par une couche de métal (10) recouvrant une couche de grille (8) d'une matière conductrice du dispositif MOS de puissance, ladite couche de grille (8) étant isolée d'une matière semi-conductrice (3) sous-jacente par une couche isolante (7), le dispositif MOS de puissance étant composé de plusieurs cellules élémentaires (1) fonctionnellement actives, obtenues dans des parties respectives de la puce (22), et de plusieurs régions (11) fonctionnellement inactives, ladite couche isolante (7) étant plus épaisse dans les régions (11) fonctionnellement inactives que dans lesdites cellules élémentaires (1) fonctionnellement actives, la couche de grille (8) et la couche de métal (10) étant élevées en conséquence au niveau desdites régions fonctionnellement inactives par rapport aux cellules élémentaires (1) fonctionnellement actives, de sorte que la pression exercée par la rondelle de contact (16) est entièrement supportée par lesdites régions (11) fonctionnellement inactives.

2. Ensemble puce et boîtier de dispositif MOS de puissance selon la revendication 1, caractérisé en ce que lesdites régions (11) fonctionnellement inactives sont intercalées entre les cellules élémentaires (1) fonctionnellement actives.

3. Ensemble puce et boîtier de dispositif MOS de puissance selon l'une quelconque des revendications précédentes, caractérisé en ce que ledit corps (21), conducteur de la chaleur, du boîtier est fait de céramique.

4. Ensemble puce et boîtier de dispositif MOS de puissance selon la revendication 3, caractérisé en ce que le boîtier est du type "à disque" ("presspack"), comprenant en outre un disque de contact (17) conducteur de l'électricité en contact mécanique avec une surface inférieure (28) de la puce (22), une première plaque (14) conductrice de l'électricité superposée sur la rondelle de contact (16), une seconde plaque (15) conductrice de l'électricité sous-jacente au disque de contact (17), le boîtier comprenant en outre une collerette supérieure (18) fermant une ouverture supérieure du corps (21) et une collerette inférieure (20) fermant une ouverture inférieure du corps (21), et une seconde plaque (13) de borne électrique externe, chaque desdites deux plaques externes (12, 13) étant en contact avec l'une, respective, desdites deux collerettes (18, 20) et constituant les bornes électriques externes du dispositif MOS de puissance.
